# EUROPEAN PATENT SPECIFICATION

(11) **EP 2 202 005 B1**
(45) Date of publication and mention of the grant of the patent: **01.01.2020**
(21) Application number: 08836355.1
(22) Date of filing: 29.09.2008
(51) Int. Cl.: B05C 11/10, B05C 5/00, B05D 1/26

(54) **LIQUID MATERIAL APPLICATOR, APPLICATION METHOD, AND PROGRAM**
APPLIKATOR FÜR FLÜSSIGES MATERIAL, AUFTRAGUNGSVERFAHREN UND PROGRAMM
APPLICATEUR DE MATIÈRE LIQUIDE, PROCÉDÉ D'APPLICATION ET PROGRAMME

(30) Priority: 01.10.2007 JP 2007258115
(43) Date of publication of application: 30.06.2010
(73) Proprietor: Musashi Engineering, Inc., Mitaka-shi, Tokyo 181-0011 (JP)
(72) Inventor: IKUSHIMA, Kazumasa, Mitaka-Shi Tokyo 181-0011 (JP)
(74) Representative: TBK
(86) International application number: PCT/JP2008/002705
(87) International publication number: WO 2009/044524

(56) References cited:
- WO-A1-2006/118088
- WO-A1-2006/118088
- JP-A- 7 008 872
- JP-A- 11 010 054
- JP-A- 2001 126 975
- JP-A- 2006 167 534
- US-A- 5 292 066
- US-A1- 2003 205 315
- US-A1- 2006 163 759

## Description

### Technical Field

The present invention relates to a method and an apparatus for continuously applying a liquid material while the liquid material is discharged in a non-constant amount by setting the number of revolutions of a screw to be variable. More particularly, the present invention relates to a liquid material applicator, an application method, and a program, which can adjust the applied amount of the liquid material depending on change of a moving speed when the liquid material is applied to a panel-like member in accordance with an application pattern made up of a corner region and a linear region.

### Background Art

In many of apparatuses for manufacturing flat panel displays, typically such as liquid crystal displays and plasma display panels (PDPs), dispensers are employed to coat a viscous material on a panel in a predetermined pattern. One widely used example of those dispensers is an air type dispenser in which air supplied from a compressed air source is applied to a liquid material in a reservoir, thus causing the liquid material to be discharged through a nozzle which is in communication with the reservoir.

Regarding an applicator using the air type dispenser, Patent Document 1, for example, discloses that the occurrence of vibration can be prevented in a corner region and a paste can be applied in a proper amount by employing an application method for drawing a rectangular pattern on a base plate, the method comprising the steps of reducing a relative speed of a nozzle and the base plate and simultaneously reducing the discharge pressure of the paste at a start point of the corner region, and after passing the corner region, increasing the relative speed of the nozzle and the base plate and simultaneously increasing the discharge pressure of the paste before reaching an end point of the corner region. Also, Patent Document 1 discloses that the above- mentioned control is performed in accordance with pattern data stored in a RAM built in a microcomputer, and respective positions of the start and end points of the corner region are determined through measurement using a linear scale.

Meanwhile, when a liquid material having high viscosity or a liquid material containing a filler is discharged, it is difficult to obtain the desired result in many cases with the discharge using the air type dispenser. As means for discharging that kind of liquid material, a screw type dispenser is proposed in which a screw having a spiral ridge provided on the surface of a rod-like member while extending in an axial direction thereof is rotated such that the spiral ridge carries the liquid material to a discharge opening with the rotation of the screw, thus causing the liquid material to be discharged.

An applicator using the screw type dispenser is disclosed in Patent Document 2, for example. Patent Document 2 discloses that, in a method of forming a pattern by discharging a paste on a substrate with a dispenser having a screw groove, the occurrence of missing, narrowing, falling of droplets, and other troubles at start and end points of an application line can be prevented by, at the start of the discharge, increasing the number of revolutions of a screw shaft and then maintaining the number of revolutions constant to perform the discharge of the paste, and by quickly reducing the number of revolutions of the screw shaft at the end of the discharge, and that control of the discharge amount of paste in sync with a moving speed of the dispenser is performed based on information regarding application positions and speeds, the information being previously programmed in a controller.

Patent Document 3 discloses a sealing gun of a sealant application unit, which controls the flow of the sealant in accordance with the value of an input signal, being attached to the end of a robot arm. The value of a signal applied to the sealant application unit is controlled in association with acceleration/deceleration control of the moving speed of the sealing gun. The moving speed of the sealing gun and the flow of the sealant discharged from the sealing gun are in direct proportion; therefore, the bead width becomes uniform independently of the moving speed of the sealing gun.

Patent Document 4 relates to a paste application device which has a pump means for discharging, from a nozzle, a paste of a quantity according to the rotation speed of a motor, movement devices for moving, relative to each other, the nozzle and a substrate along a substrate surface, and a control device for controlling the motor of the pump means and the movement devices.

Patent Document 1: JP 2005-218971 A
Patent Document 2: JP 3 769 261 B
Patent Document 3: US 5 292 066 A
Patent Document 4: WO 2006/118088 A1

### Disclosure of the Invention

### Problems to be Solved by the Invention

Hitherto, the discharge amount of the liquid material has been usually changed by changing the discharge pressure. However, it has been difficult to keep the applied amount of the liquid material and the shape of the applied liquid material uniform over an entire region, including a corner region and a linear region, due to delays in, e.g., the time from transmission of a pressure change signal to actual delivery of changed pressure to the liquid material, and in the response time of the liquid material after the delivery of the changed pressure.

Also, it has hitherto been usual that control data containing the moving speed of the dispenser, the position information, the applied amount of the liquid material, etc. in a correlated manner is previously set in a controller, and control for changing the applied amount is performed based on the control data. However, optimum control information has to be previously prepared in order to perform such control. There has been a difficulty in preparing, per application pattern, many items of control data in consideration of various factors, e.g., variations in environmental conditions such as temperature and humidity, and variations in viscosity of the liquid material over time.

It is an object of the present invention to provide a liquid material applicator, an application method, and a program which can solve the problems, such as a delay in the response time of a liquid material and variations in viscosity over time, without preparing many items of control data in advance.

### Means for Solving the Problems

This object is solved by the liquid material applicator according to claim 1 and a liquid material application method according to claim 8. Further advantageous developments are subject-matters of the dependent claims. The present invention resides in a liquid material applicator stated in the following [1] to [7].
[1] A liquid material applicator comprising a discharge unit which includes a screw type dispenser for discharging a liquid material, a table on which a work piece is placed, drive means for relatively moving the discharge unit and the work piece, a measurement unit for measuring a discharge amount of the liquid material applied to the work piece, and a control module for controlling operations of those components, wherein the control module has a response time calculating function being capable of, prior to the start of application, calculating a response delay time generated with change of the discharge amount of the liquid material when the work piece and the discharge unit are relatively moved at non-constant speeds and the liquid material is continuously applied into a drawing pattern with the liquid material discharged in a non-constant amount, the response time adjusting function including a first step of transmitting a signal for changing the discharge amount to the discharge unit during the application in which a relative moving speed is held constant, and storing the time of the signal transmission, a second step of calculating the time at which the discharge amount starts to be changed, by measuring the applied liquid material, and storing the calculated time, and a third step of storing a differential value between the time stored in the first step and the time stored in the second step as the response delay time (Td) generated when the discharge amount of the liquid material is changed.
[2] In the liquid material applicator stated in [1], the control module has a response time adjusting function being capable of, prior to the start of application, adjusting a response delay time generated with change of the discharge amount of the liquid material when the work piece and the discharge unit are relatively moved at non-constant speeds and the liquid material is continuously applied into a drawing pattern with the liquid material discharged in a non-constant amount, the response time adjusting function including (A) an A1 step of transmitting a signal for changing the discharge amount to the discharge unit during the application in which the table and the discharge unit are relatively moved at a constant speed, and storing the time of the signal transmission, an A2 step of calculating the time at which the discharge amount starts to be changed, by measuring the applied liquid material, and storing the calculated time, and an A3 step of storing a differential value between the time stored in the A1 step and the time stored in the A2 step as the response delay time (Td) generated when the discharge amount is changed, (B) a B1 step of changing a relative moving speed during the application in which the table and the discharge unit are relatively moved at non-constant speeds, storing the time of changing the relative moving speed, and performing the application by transmitting a signal for changing the discharge amount to the discharge unit in accordance with the response delay time (Td), a B2 step of calculating the time at which the discharge amount starts to be changed, by measuring the applied liquid material, and storing the calculated time, and a B3 step of storing a differential value between the time stored in the B1 step and the time stored in the B2 step as a response lag time (Tdd) generated when the discharge amount is changed, and (C) a C step of adjusting a gradient of change in the discharge amount of the liquid material such that the response delay time (Td) and the response lag time (Tdd) are matched with each other.
[3] In the liquid material applicator stated in [1] or [2], the control module has a discharge amount adjusting function being capable of, prior to the start of application, performing an adjustment such that the applied liquid material has a constant volume per unit length, the discharge amount adjusting function including a first step of measuring a volume of the liquid material applied to the work piece per unit length and storing the volume as a measured applied amount, a second step of calculating an increase/decrease rate that is obtained by dividing a preset target value by the measured applied amount, and storing the calculated increase/decrease rate, and a third step of calculating a next discharge amount condition based on a value obtained by multiplying the current discharge amount by the increase/decrease rate stored in the second step, and storing the next discharge amount condition. Here, the term "discharge amount condition" means a setting value representing at least one of pressure applied to the liquid material, the number of revolutions of the screw, etc.
[4] In the liquid material applicator stated in [3], only when the measured applied amount exceeds an allowable range of the target value, the control module is configured to calculate the increase/decrease rate in the second step and executes the third step.
[5] In the liquid material applicator stated in any one of [1] to [4], the control module is configured to control the number of revolutions of the screw and pressure of compressed gas applied to the liquid material.
[6] In the liquid material applicator stated in any one of [1] to [5], the measurement unit includes a camera and/or a laser displacement meter.
[7] In the liquid material applicator stated in any one of [1] to [6], the applicator further comprises a table for adjustment on which a work piece for adjustment is placed.

Also, the present invention resides in a liquid material application method stated in the following [8] to [14] and a program stated in the following [15].
[8] A liquid material application method for continuously applying a liquid material to a work piece by relatively moving the work piece placed on a table and a discharge unit including a screw type dispenser, which is opposed to the work piece, at a non-constant speed with the liquid material discharged in a non-constant amount, the method including a response time calculating step of, prior to the start of application, calculating a response delay time generated when the discharge amount of the liquid material is changed, wherein the response time calculating step includes a first step of transmitting a signal for changing the discharge amount to the discharge unit during the application in which a relative moving speed is held constant, and storing the time of the signal transmission, a second step of calculating the time at which the discharge amount starts to be changed, by measuring the applied liquid material, and storing the calculated time, and a third step of storing a differential value between the time stored in the first step and the time stored in the second step as the response delay time (Td) generated when the discharge amount is changed.
[9] A liquid material application method stated in [8], the method including a response time adjusting step of, prior to the start of application, adjusting a response delay time generated when the discharge amount of the liquid material is changed, wherein the response time adjusting step includes (A) an A1 step of transmitting a signal for changing the discharge amount to the discharge unit during the application in which the table and the discharge unit are relatively moved at a constant speed, and storing the time of the signal transmission, an A2 step of calculating the time at which the discharge amount starts to be changed, by measuring the applied liquid material, and storing the calculated time, and an A3 step of storing a differential value between the time stored in the A1 step and the time stored in the A2 step as the response delay time (Td) generated when the discharge amount is changed, (B) a B1 step of changing a relative moving speed during the application in which the table and the discharge unit are relatively moved at non-constant speeds, storing the time of changing the relative moving speed, and performing the application by transmitting a signal for changing the discharge amount to the discharge unit in accordance with the response delay time (Td), a B2 step of calculating the time at which the discharge amount starts to be changed, by measuring the applied liquid material, and storing the calculated time, and a B3 step of storing a differential value between the time stored in the B1 step and the time stored in the B2 step as a response lag time (Tdd) generated when the discharge amount is changed, and (C) a C step of adjusting a gradient of change in the discharge amount of the liquid material such that the response delay time (Td) and the response lag time (Tdd) are matched with each other.
[10] In the liquid material application method stated in [9], when the relative moving speed is changed plural times, the A2 step and the B2 step are executed by measuring the applied liquid material at plural points near each of positions at which the relative moving speed is changed, calculating average values of changes of the discharge amount for the plural positions from measured values, and calculating, based on the average values, the time at which the discharge amount starts to be changed, and the C step is executed by calculating the gradient of change in the discharge amount of the liquid material based on the average values of changes of the discharge amount, which have been calculated in the B2 step.
[11] In the liquid material application method stated in [9] or [10], when an application pattern is made up of a linear region and a corner region, an application speed is reduced in the corner region than that in the linear region.
[12] In the liquid material application method stated in [11], the application pattern has a substantially rectangular shape in which the corner region is in the form of a curved line.
[13] A liquid material application method stated in [8] or [9], the method including a discharge amount adjusting step of, prior to the start of application, performing an adjustment such that the applied liquid material has a constant volume per unit length, the discharge amount adjusting step comprising a first step of measuring a volume of the liquid material applied to the work piece per unit length and storing the volume as a measured applied amount, a second step of calculating an increase/decrease rate that is obtained by dividing a preset target value by the measured applied amount, and storing the calculated increase/decrease rate, and a third step of calculating a next discharge amount condition based on a value obtained by multiplying the current discharge amount by the increase/decrease rate stored in the second step, and storing the next discharge amount condition. The meaning of the term "discharge amount condition" is the same as that mentioned in the above [3].
[14] In the liquid material application method stated in [13], only when the measured applied amount exceeds an allowable range of the target value in the second step, the increase/decrease rate is calculated in the second step and the third step is executed.
[15] A program comprising instructions which, when the program is executed by an applicator, cause the applicator to carry out the liquid material application method stated in any one of claims 8 to 14.

### Effect of the Invention

According to the present invention, the actually applied liquid material is measured, and the relative moving speed, the discharge amount, etc. are adjusted based on the measured result. Hence, there is no need of preparing, per application pattern, many items of control data in consideration of various factors, e.g., variations in environmental conditions such as temperature and humidity, and variations in viscosity of the liquid material over time.

Further, the present invention is quickly adaptable for variations in environmental conditions, variations in viscosity of the liquid material over time, etc.

### Brief Description of the Drawings

[Fig. 1] Fig. 1 is a schematic perspective view of an applicator according to an embodiment.
[Fig. 2] Fig. 2 is a sectional view of principal part to explain a screw type dispenser according to the embodiment.
[Fig. 3] Fig. 3 illustrates graphs to explain calculation of a response delay time.
[Fig. 4] Fig. 4 is an explanatory view to explain change of a moving speed in a corner region.
[Fig. 5] Fig. 5 illustrates graphs, etc. to explain adjustment of response of the liquid material in adjusting an XYZ operation and a screw operation.
[Fig. 6] Fig. 6 illustrates graphs, etc. to explain adjustment of a proportion at which the discharge amount of the liquid material is changed in adjusting the XYZ operation and the screw operation.
[Fig. 7] Fig. 7 is a flowchart showing procedures for calculating the response delay time.
[Fig. 8] Fig. 8 is a flowchart showing procedures for adjusting the discharge amount.
[Fig. 9] Fig. 9 is a flowchart showing procedures for adjusting the response of the liquid material in adjusting the XYZ operation and the screw operation.
[Fig. 10] Fig. 10 is a flowchart showing procedures for adjusting the proportion at which the discharge amount is changed in adjusting the XYZ operation and the screw operation.
[Fig. 11] Fig. 11 is a schematic perspective view showing the progress of the application.

### Description of Reference Characters

A legend of main reference characters used in the drawings is as follows:
1 applicator / 2 discharge unit / 3 measurement unit / 5 drive unit / 6 application target / 7 table / 8 table for adjustment / 9 application pattern / 10 nozzle / 11 corner region / 12 application start point / 13 applying direction / 100 main body / 101 screw / 102 rotation drive mechanism (motor) / 103 screw insertion bore / 104 liquid material supply opening / 105 nozzle / 106 sealing member / 107 screw distal end / 108 screw proximal end / 200 communication flow passage / 201 reservoir (syringe) / 202 reservoir attachment opening / 203 first flow passage / 204 second flow passage / 205 adapter tube / 300 liquid material / 301 flow of liquid material

### Best Mode for Carrying out the Invention

The best mode for carrying out the present invention will be described below. In the following description, the volume of liquid material flowing out from a nozzle per unit time is called "discharge amount", and the volume of liquid material applied to a work piece per unit length is called "applied amount".

### (1) Calculation of response delay time

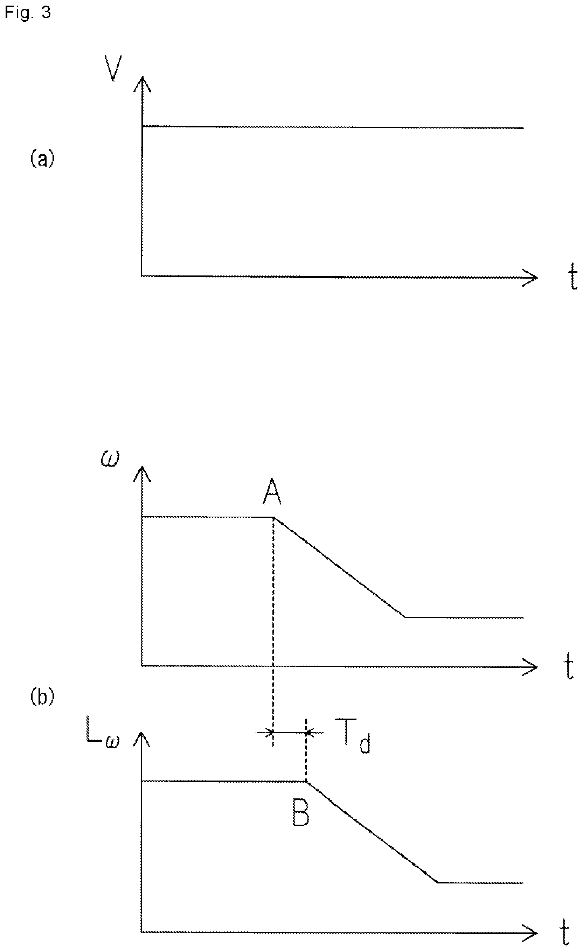

Procedures for calculating a response delay time from transmission of a discharge amount change signal to actual change of the amount of the liquid material when the discharge amount of a discharge unit including a screw type dispenser is changed will be described below with reference to Fig. 3(b). The discharge amount of the liquid material discharged when the moving speed V and the number of revolutions of the screw co type dispenser are held constant is as per shown in Fig. 3(a).

First, the liquid material is applied on condition that only the number of revolutions of a screw co in the screw type dispenser is changed without changing the moving speed V. Then, the applied liquid material is measured for the applied amount (such as the sectional area, the width, and the height) at plural positions before and after a point A where the number of revolutions of the screw ω is instructed to start to be changed. An actual discharge-amount change start point B where a discharge amount of the liquid material L_{ω} actually starts to be changed is determined from the plural measured results. Then, a time T_{d} from the transmission of the discharge amount change signal to the actual change of the discharge amount is calculated based on a distance between the change start point A and the actual discharge-amount change start point B and the moving speed V. The time thus calculated is a response delay time T_{d}. Here, an application pattern is not required to include a corner region, and it may include only a linear region.

From the viewpoint of increasing stability, it is preferable that the application and the measurement are repeated plural times in a similar manner, and the measured results are averaged.

### (2) Adjustment of discharge amount

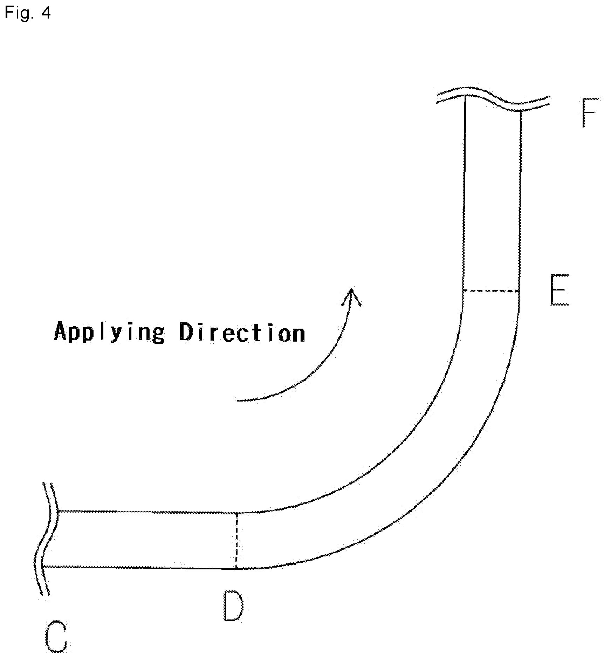

Adjustment of the discharge amount will be described below with reference to an application pattern, shown in Fig. 4, which is made up of one corner region and two linear regions sandwiching the corner region from both sides.

When the liquid material is applied in accordance with an application pattern including a corner region, the application is performed while the moving speed is reduced in the corner region. The moving speed is changed in the corner region as follows.

First, a nozzle is moved at a speed V₁ in a direction from the left side to the right side, as viewed on Fig. 4, while discharging the liquid material. When the nozzle reaches a point C before the corner region, the nozzle is started to slow down such that the nozzle speed is reduced to a speed V₂ during a period until reaching a point D immediately before the corner region. After curving along the corner region while maintaining the speed V₂ constant, the nozzle is started to speed up when reaching a point E immediately after the corner region. The nozzle speed is increased to the speed V₁ during a period until reaching a point F, and the nozzle is further moved upwards, as viewed on Fig. 4, at the constant speed.

When the nozzle speed is changed in the corner region, a problem that the applied amount and the shape of the applied liquid material become non-uniform is caused unless the discharge amount of the liquid material is also changed in step with the change of the moving speed of the nozzle. To avoid such a problem, in this embodiment, the discharge amount is changed by changing the number of revolutions of the screw. Adjusting the discharge amount by changing the number of revolutions of the screw is preferable in that higher response is obtained than the case of using pressure to adjust the discharge amount, and that the discharge amount and the shape of the applied liquid material are kept uniform before and after the change of the moving speed.

The discharge amount is tentatively adjusted such that the applied amount is provided as a desired amount in each of the linear region and the corner region.

First, the liquid material is applied while the moving speed and the number of revolutions of the screw are changed in the corner region. Then, the applied liquid material is measured for the applied amount (such as the sectional area, the width, and the height) at plural positions in each of the two linear regions (between C and D and between E and F) which are adjacent to the corner region. An average value of the measured values of the discharge amount is determined from the values measured at the plural positions in each of the C-D region and the E-F region.

When the measured value of the applied amount exceeds an allowable range (threshold) of a target value, the discharge amount is adjusted. The discharge amount is adjusted by multiplying a discharge amount condition immediately before the measurement by an increase/decrease rate, and setting the resulting product as a new discharge amount condition. Here, the term "increase/decrease rate" means a value obtained by dividing the target value of the applied amount by the measure value (average value) of the applied amount. The discharge amount condition is set by adjusting the pressure of a compressed gas that is applied to the liquid material in a reservoir and the number of revolutions of the screw driven by a motor.

The above-described procedures are repeated until the measure value is converted within the allowable range.

### (3) Adjustment of XYZ operation and operation of screw type dispenser

A method for adjusting the discharge amount depending on the speed change in the corner region will be described below. Because the principle of the adjusting method is basically the same in both the cases of deceleration (slow-down) and acceleration (speed-up), the following description is made only about the case of deceleration.

When the moving speed of the nozzle is decelerated, the discharge amount is adjusted to be decreased in match with the deceleration for the reason that the applied amount is increased during the deceleration if the discharge amount is held constant.

First, the discharge amount is decreased in match with the deceleration of the moving speed, and the position where the number of revolutions of the screw is started to decrease is adjusted, taking into account the response delay time T_{d} calculated in the above (1), such that the applied amount is kept uniform before and after the speed change. Preferably, the adjustment is also performed for variations in the liquid material condition, which are caused by, e.g., variations in environmental conditions and variations in properties of the liquid material (e.g., variations in viscosity over time) and which cannot be fully adjusted in consideration of only the response delay time T_{d}.

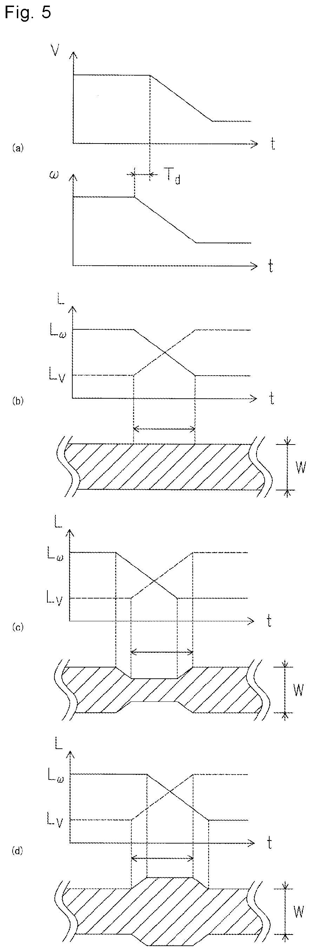

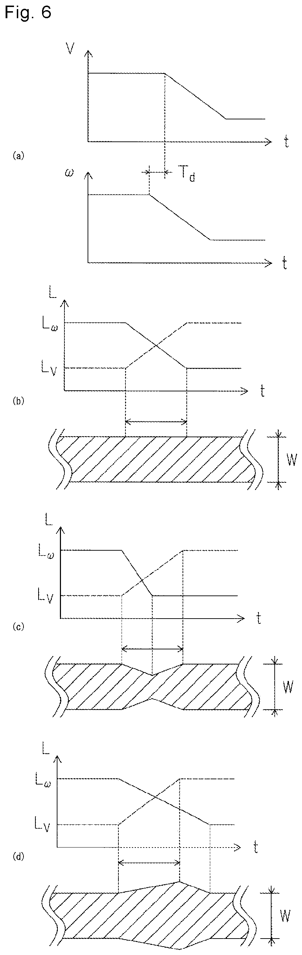

The above-described adjustment can be performed by (A) adjusting the response of the liquid material, and (B) adjusting a rate at which the discharge amount is changed. The adjusting methods (A) and (B) will be described below with reference to Figs. 5 and 6. It is assumed that, in Figs. 5 and 6, the application is progressed from the left to the right.

### (A) Adjustment of response of liquid material

Fig. 5(a) represents the relationship between change of the moving speed V and change of the number of revolutions of the screw ω. The change of the number of revolutions of the screw ω is adjusted such that the change is started earlier corresponding to the response delay time T_{d} calculated in the above (1). The following description is made on condition that a rate of the change of the discharge amount with respect to the change of the number of revolutions of the screw is held constant.

If the position where the discharge amount L_{ω} is started to decrease with the decrease of the number of revolutions of the screw ω is appropriate with respect to the start of the increase of the applied amount L_{V}, which is caused by the deceleration of the moving speed V, L_{ω} is changed in good match with the change of L_{V} such that a line width W representing the application result is kept constant, as shown in Fig. 5(b). It is needless to say that, in the above case, an adjustment of the discharge amount is not required because the applied amount is constant.

If the point where the discharge amount L_{ω} is started to decrease with the decrease of the number of revolutions of the screw ω is earlier than the start of the increase of the applied amount L_{V}, which is caused with the deceleration of the moving speed V, the decrease of L_{ω} is started earlier than the increase of L_{V} and hence the line width W representing the application result decreases in an initial stage, as shown in Fig. 5(c). Thereafter, when L_{V} starts to increase, the line width W is increased or kept constant depending on the relationship between L_{ω} and L_{V}. Because the change of L_{ω} is terminated earlier than the change of L_{V}, the line width W continues to increase until the change of L_{V} is terminated. After the change of L_{V}, the line width W returns to the same state as that before the change.

To determine a lag of the point where the discharge amount L_{ω} is started to be decrease with respect to the start of the decrease in the number of revolutionsof the screw ω, which is the cause of the mismatch described above with reference to Fig. 5(c), the applied amount in terms of, e.g., the line width W is first measured at plural points before and after the position where the deceleration of the moving speed V is started. When the measured values of the line width W indicate that there is a position where the line width W starts to decrease, this is determined as indicating that the start of the decrease of L_{ω} is earlier, and such a position is regarded as the position where L_{ω} starts to decrease. Then, the time from the start of the decrease in the number of revolutions of the screw ω to the start of the decrease of the discharge amount L_{ω} is determined and regarded as a response lag time T_{dd}. The adjustment is performed by retarding the point where the number of revolutions of the screw ω is started to decrease, such that the response lag time T_{dd} matches with the response delay time T_{d} calculated in the above (1).

If the point where the discharge amount L_{ω} is started to decrease with the decrease of the number of revolutions of the screw ω is later than the start of the increase of the applied amount L_{V}, which is caused by the deceleration of the moving speed V, the increase of L_{V} is started earlier than the decrease of L_{ω} and hence the line width W representing the application result is increased in an initial stage, as shown in Fig. 5(d). Thereafter, when L_{ω} starts to decrease, the line width W is decreased or kept constant depending on the relationship between L_{ω} and L_{V}. Because the change of L_{V} is terminated earlier than the change of L_{ω}, the line width W continues to decrease until the change of L_{ω} is terminated. After the change of L_{ω}, the line width W returns to the same state as that before the change.

To determine a lag of the point where the discharge amount L_{ω} is started to decrease with respect to the start of the decrease in the number of revolutions of the screw ω, which is the cause of the mismatch described above with reference to Fig. 5(d), the applied amount in terms of the line width W is first measured at plural points before and after the position where the deceleration of the moving speed V is started. When the measured values of the line width W indicate that there is a position where the line width W is changed from the increase to the decrease (or to a constant value), this is determined as indicating that the start of the decrease of L_{ω} is later, and such a position is regarded as the position where L_{ω} starts to decrease. Then, the time from the start of the decrease in the number of revolutions of the screw ω to the start of the decrease of the discharge amount L_{ω} is determined and regarded as a response lag time T_{dd}. The adjustment is performed by advancing the point where the number of revolutions of the screw ω is started to decrease, such that the response lag time T_{dd} matches with the response delay time T_{d} calculated in the above (1).

### (B) Adjustment of change rate of discharge amount

Fig. 6(a) represents the relationship between change of the moving speed V and change of the number of revolutions of the screw ω. The change of the number of revolutions of the screw ω is adjusted such that the change is started earlier corresponding to the response delay time T_{d} calculated in the above (1). The following description is made on condition that the start position of the change of the discharge amount caused by the change of the number of revolutions of the screw is held constant.

If a decrease rate (represented by a gradient) of the discharge amount L_{ω} within a deceleration zone S_{V} of the moving speed V is appropriate with respect to an increase rate of the applied amount L_{V} within the deceleration zone S_{V}, L_{ω} is changed in good match with the change of L_{V} such that the line width W representing the application result is kept constant, as shown in Fig. 6(b). It is needless to say that, in the above case, the adjustment is not required because the applied amount is constant.

If the decrease rate of the discharge amount L_{ω} within the deceleration zone S_{V} is larger than the increase rate of the applied amount L_{V} within the deceleration zone S_{V}, the line width W representing the application result decreases in an initial stage, as shown in Fig. 6(c), because the decrease rate of L_{ω} is comparatively large. Thereafter, the change of L_{ω} is terminated earlier, and hence the line width W continues to increase until the change of L_{V} is terminated. After the change of L_{V}, the line width W returns to the same state as that before the change.

To determine a deviation of the decrease rate of the discharge amount L_{ω} with respect to a decrease rate of the number of revolutions of the screw ω, which is the cause of the mismatch described above with reference to Fig. 6(c), the line width W is first measured at plural points within the deceleration zone S_{V}. When the measured values of the line width W represent that there is a zone where the line width W decreases, this is determined as indicating that the decrease rate of L_{ω} is comparatively large, and the decrease rate of the discharge amount L_{ω} is calculated from both a decrease rate of the line width W and a deceleration rate of the moving speed V in such a zone. Then, the adjustment is performed by reducing the decrease rate of the number of revolutions of the screw ω to be matched with the deceleration rate of the moving speed V.

If the decrease rate of the discharge amount L_{ω} within the deceleration zone S_{V} is smaller than the increase of the applied amount L_{V} within the deceleration zone S_{V}, the line width W representing the application result is increased in an initial stage, as shown in Fig. 6(d), because the decrease rate of L_{ω} is comparatively small. Thereafter, the change of L_{V} is terminated earlier, and hence the line width W continues to decrease until the change of L_{ω} is terminated. After the change of L_{ω}, the line width W returns to the same state as that before the change.

To determine a deviation of the decrease rate of the discharge amount L_{ω} with respect to the decrease rate of the number of revolutions of the screw ω, which is the cause of the mismatch described above with reference to Fig. 6(d), the line width W is first measured at plural points within the deceleration zone S_{V}. When the measured values of the line width W represent that there is a zone where the line width W increases, this is determined as indicating that the decrease rate of L_{ω} is comparatively small, and the decrease rate of the discharge amount L_{ω} is calculated from both a decrease rate of the line width W and a deceleration rate of the moving speed V in such a zone. Then, the adjustment is performed by increasing the decrease rate of the number of revolutions of the screw ω to be matched with the deceleration rate of the moving speed V.

In the actual application, the mismatches described in the above (A) and (B) are generated not separately and may be generated at the same time. It is, therefore, preferable to improve accuracy of the adjustment by performing the adjustment in the above (A) and then continuously performing the adjustment in the above (B). More preferably, a series of procedures described in each of the above (A) and (B) is repeated plural times to further improve the accuracy.

While the present invention will be described in more detail in connection with an embodiment, it is to be noted that the present invention is in no way limited by the following embodiment.

### Embodiment

While the present invention will be described in more detail in connection with an embodiment, it is to be noted that the present invention is in no way limited by the following embodiment.

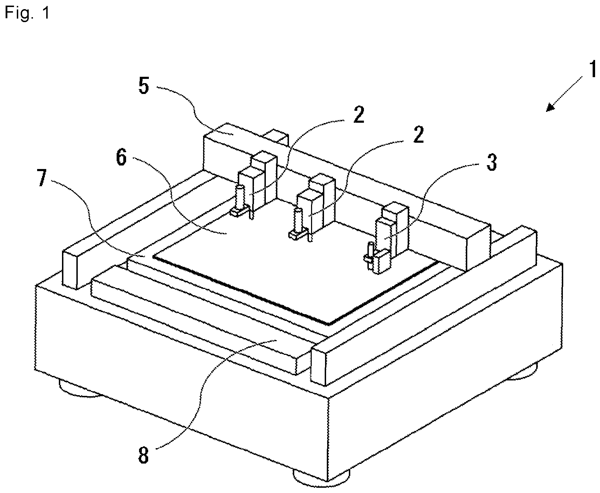

Fig. 1 is a schematic perspective view of an applicator according to an embodiment.

An applicator 1 includes a discharge unit 2 for discharging the liquid material, a measurement unit 3 for measuring the amount of the liquid material applied to a work piece 6, a table 7 on which the work piece 6 as a target of the application of the liquid material is placed, and XYZ drive means on which the discharge unit 2 and the measurement unit 3 are disposed and which is operated to relatively move both the units on the table 7 in XYZ directions.

Separately from the table 7 on which the work piece 6 is placed, a table 8 for adjustment is disposed to hold thereon a dummy work piece to which the liquid material is applied for adjustment.

The discharge unit 2 for discharging the liquid material is such a screw type dispenser that a screw is rotated by a motor to discharge the liquid material, which is supplied under pressure from a reservoir, through a nozzle. The screw type dispenser is connected to a dispenser controller serving as a discharge control means (not shown), and the number of revolutions of the motor and the pressure of compressed gas applied to the liquid material within the reservoir are controlled by the dispenser controller.

The measurement unit 3 is constituted by either one or both of a camera for measuring the width of a line of the applied liquid material from a taken image of the liquid material, and a laser displacement meter for measuring the difference between the work piece surface and the surface of the liquid material by using a laser and obtaining the height or the cross-sectional area of the applied liquid material. The discharge unit 2 and the measurement unit 3 may be disposed separately from each other. Alternatively, the measurement unit may be disposed close to the discharge unit so as to constitute an integral unit. Further, the discharge unit 2 and the measurement unit 3 are preferably movable by a Z drive means in a direction perpendicular to the work piece surface. The above-described components are connected to a control module (not shown) including a main storage module and a processing module such that operations of those components are controlled by the control module.

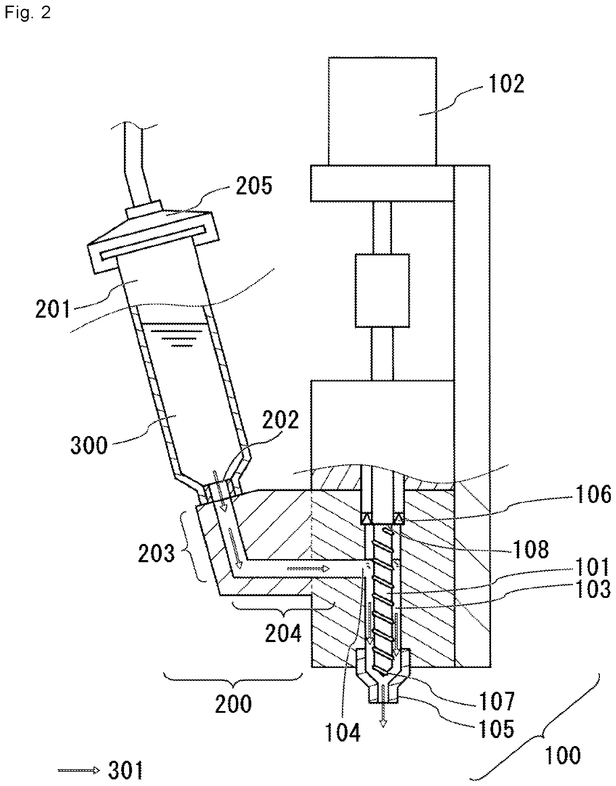

Fig. 2 is a sectional view of principal part to explain the screw type dispenser according to the embodiment.

The screw type dispenser according to the embodiment includes a main body 100, a screw 101 having a spiral ridge provided on the surface of a rod-like member while extending in an axial direction thereof, a motor 102 that serves as a rotation drive mechanism for rotating the screw 101, a nozzle 105 mounted to a screw distal end 107 and communicating with a screw insertion bore 103, and a sealing member 106 through which the screw 101 is inserted.

In the main body 100, there are formed the screw insertion bore 103 in which the screw 101 is inserted, a liquid material supply opening 104 which is formed on a side of the screw insertion hole 103 and to which a liquid material 300 is supplied, and a communicating passage 200.

The communicating passage 200 serves as a passage for introducing the liquid material 300 to the liquid material supply opening 104, and it is made up of a reservoir attachment opening 202 to which a syringe 201 serving as the reservoir is attached, a first flow passage 203 communicating with the reservoir attachment opening 202 and having such a slope as causing the liquid material to flow in a direction toward a central axis of the screw insertion bore 103, and a second flow passage 204 communicating the first flow passage 203 and the liquid material supply opening 104 of the main body 100 with each other and causing the liquid material to flow in a direction perpendicular to the central axis of the screw insertion bore 103. In this embodiment, since the communicating passage 200 and the main body 100 are formed integrally with each other, the number of sealing member is minimized.

The syringe 201 is connected to the reservoir attachment opening 202. With the compressed gas supplied through an adapter tube 205 which is attached to a top of the syringe 201, the liquid material 300 is supplied under pressure to the liquid material supply opening 104 of the main body through the communicating passage 200. In this embodiment, the first flow passage 203 is sloped to reduce resistance exerted on the liquid material when supplied under pressure.

Further, the degree of freedom in shape of the syringe 201 is increased by arranging the syringe 201, which is attached to the reservoir attachment opening 202, to be sloped in alignment with the first flow passage 203. Such an arrangement of the syringe 201 is advantageous, for example, in that even when the syringe 201 has a large size in a width direction thereof, the syringe 201 is less apt to interfere with the main body 100 and the communicating passage 200 is not required to be extended to avoid the interference. In other words, the embodiment has a structure capable of minimizing the extension of the communicating passage 200, which is required with an increase of the syringe size, and hence capable of suppressing an increase of the pressure applied to supply the liquid material, which is also required with an increase of the syringe size.

In a discharge step, the compressed gas is supplied to the interior of the syringe 201 through the adapter tube 205, whereupon the liquid material 300 reserved in the syringe 201 is supplied to the communicating passage 200 through the reservoir attachment opening 202 so as to flow into the screw insertion bore 103 through the liquid material supply opening 104.

The liquid material 300 flowing into the screw insertion bore 103 is pressed by the compressed air. It is, therefore, supposed that part of the supplied liquid material flows upwards. However, because a liquid block space is formed adjacent to the sealing member 106, the liquid material 300 is prevented from directly reaching the sealing member 106. Further, because the liquid material is forced to be moved downwards by the spiral ridge that is positioned above the liquid material supply opening 104, the liquid material 300 is prevented from remaining near the sealing member 106. Thus, because the liquid material 300 is prevented from reaching the sealing member 106, it is possible to lower the contact surface pressure of the sealing member 106 against the screw 101, and to minimize the problem of a wear.

The liquid material 300 having flown into the screw insertion bore 103 through the liquid material supply opening 104 is moved toward the screw distal end 107 in the screw insertion bore 103 with rotation of the screw 101 which is rotated by the motor 102. The liquid material is then discharged through the nozzle 105 mounted to the lower end of the screw insertion bore 103.

The above-described flow of the liquid material 300 from the syringe 201 to the nozzle 105 is indicated by arrows 301 in Fig. 2.

At the end of the discharge, the rotation of the screw 101 is stopped by stopping the rotation of the motor 102, and the discharge can be terminated by stopping the supply of the compressed gas that has been supplied to the syringe 201.

### <<Procedures for adjustment of discharge amount>>

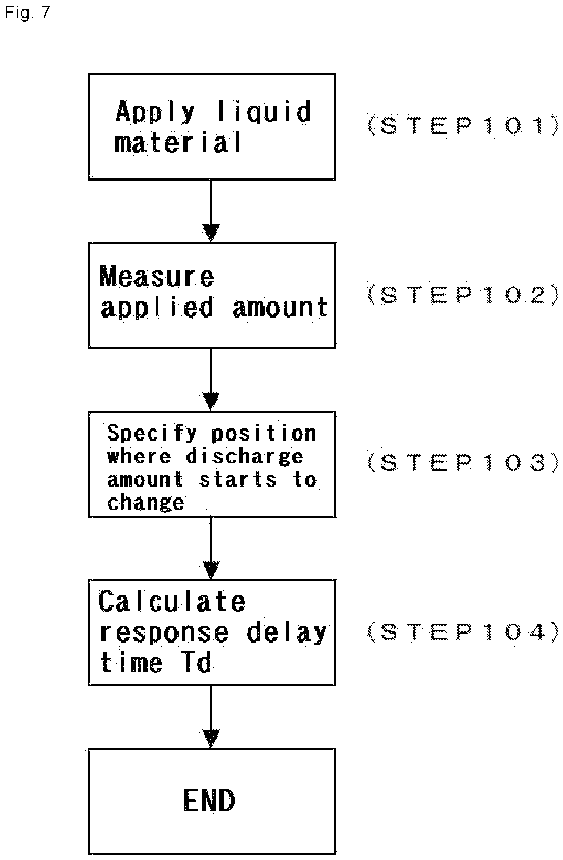

Procedures for adjusting the discharge amount depending on change of the relative moving speed between the nozzle and the work piece will be described below with reference to Figs. 7 to 10 by referring to the case where the liquid material is applied in accordance with an application pattern which is made up of a corner region and a linear region.

As a first procedure, the response delay time T_{d} is calculated as shown in Fig. 7. The liquid material is first applied to the work piece or the dummy work piece for adjustment by changing only the number of revolutions of the screw in the screw type dispenser while the moving speed is kept constant (STEP 101). Then, the applied amount of the liquid material is measured at plural positions before and after the point where the number of revolutions of the screw is started to change (STEP 102). Then, the point where the discharge amount starts to change is specified (STEP 103) from the results measured in STEP 102. Further, the response delay time T_{d} is calculated (STEP 104) from the point where the number of revolutions of the screw is started to change, the point specified in STEP 103, and the moving speed. This procedure is then brought to an end.

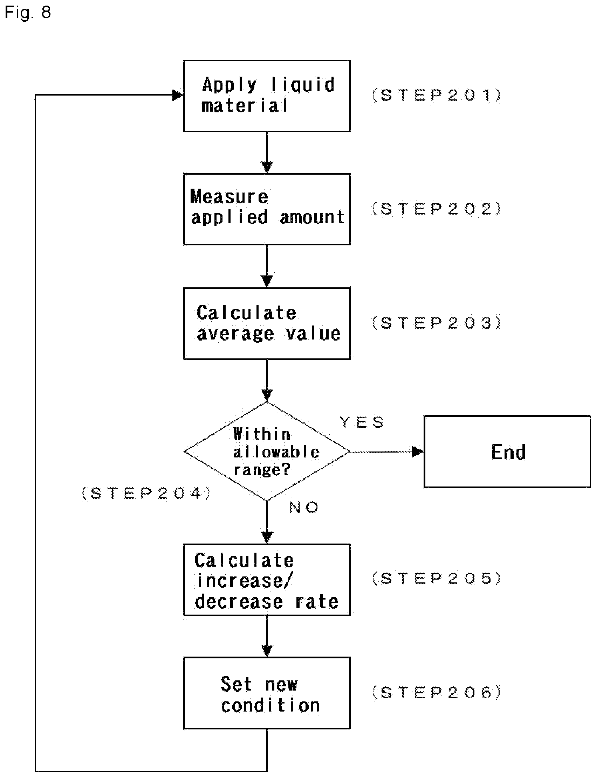

As a second procedure, the discharge amount is adjusted as shown in Fig. 8. The liquid material is first applied to the work piece or the dummy work piece for adjustment in accordance with the application pattern made up of the corner region and the linear region while the moving speed and the number of revolutions of the screw are changed in the corner region (STEP 201). Then, the applied amount of the liquid material is measured at plural positions in each of the corner region and the linear region adjacent to the corner region (STEP 202). Then, average values of the results measured in STEP 202 are calculated for each of the corner region and the linear region (STEP 203). The calculated average values are each compared with an allowable range of a preset target value (STEP 204). If the average value is within the allowable range, the procedure is brought to an end. If the average value exceeds the allowable range, an increase/decrease rate is calculated based on a ratio of each average value (measured value) to the target value (STEP 205). The increase/decrease rate calculated in STEP 205 is multiplied by the original discharge amount condition, and a resulting value is set as a new discharge amount condition (STEP 206). STEP 201 to STEP 203 are executed again, and if the result determined in STEP 204 is within the allowable range, the procedure is brought to an end. The above- described procedure is repeated until the result determined in STEP 204 falls within the allowable range. Be it noted that STEP 204 may be executed prior to STEP 203.

Let assume, for example, that when a target value of the cross-sectional area of the linear region is 6000 [µm²] and the allowable range is ± 5% of the target value, the measured value is 6600 [µm²]. Because the measured value exceeds an upper limit value (target value + 5% = 6300 [µm²]) of the allowable range, an adjustment is performed as follows. A ratio of the target value to the measured value is calculated, namely, (target value) / (measured value) = about 0.9. Such a ratio is defined as the increase/decrease rate. When the current number of revolutions of the screw, i.e., the discharge amount condition in executing the application, is 3000 [rpm], a value (3000 × 0.9 = 2700 [rpm]) resulting from multiplying the current number of revolutions of the screw by the increase/decrease rate is set as the new number of revolutions of the screw, i.e., the new discharge amount condition. For the corner region, the adjustment of the discharge amount is performed according to a similar procedure.

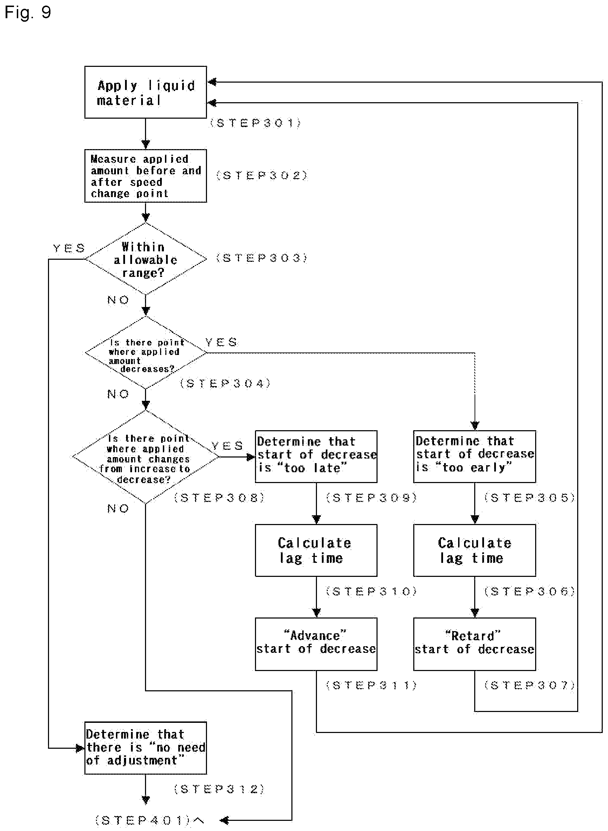

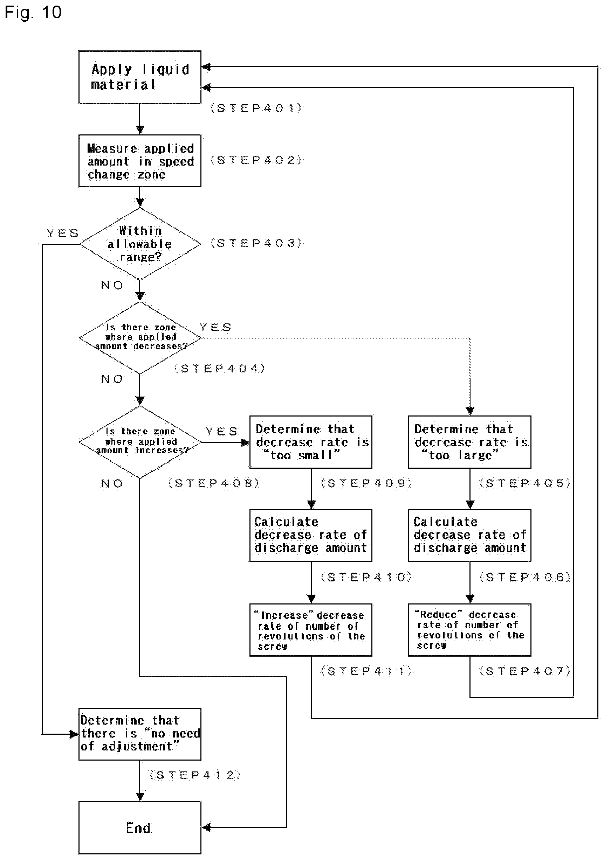

As a third procedure, adjustments of the XYZ operation and the screw operation are performed as shown in Figs. 9 and 10. The following description is made only about the case of decelerating the moving speed.

Initially, an adjustment of the response of the liquid material is performed as shown in Fig. 9. The liquid material is first applied to the work piece or the dummy work piece for adjustment in accordance with the application pattern made up of the corner region and the linear region while the moving speed and the number of revolutions of the screw are changed in the corner region (STEP 301). Then, the applied amount of the liquid material is measured at plural positions before and after the point where the moving speed is started to change (STEP 302). Then, the results measured in STEP 302 are each compared with a preset allowable range (STEP 304). If the measured value is within the allowable range, the procedure is shift to an adjustment procedure (STEP 401) for a discharge amount change rate, described later, based on determination that there is "no need of adjustment" (STEP 312). If the measured value exceeds the allowable range, it is determined based on the results measured at the plural points in STEP 302 whether there is a point at which the applied amount decreases (STEP 304). If there is no such point, the procedure is shifted to STEP 308. If there is such a point, this is determined as indicating that the start of the decrease of the discharge amount corresponding to the start of the decrease in the number of revolutions of the screw is too early (STEP 305). Further, a time from the start of the decrease in the number of revolutions of the screw to the start of the decrease of the discharge amount (i.e., a lag time T_{dd}) is calculated (STEP 306). An adjustment is performed (STEP 307) to retard the position where the number of revolutions of the screw is started to decrease, such that the lag time T_{dd} matches with the delay time T_{d} calculated in STEP 104. After the adjustment, the above-described procedure is executed again from STEP 301. If it is determined in STEP 304 that there is no point at which the applied amount decreases, it is determined based on the results measured at the plural points in STEP 302 whether there is a point at which the applied amount changes from an increase to a decrease (STEP 308). If there is no such point, the procedure is shifted to STEP 401 described later. If there is such a point, this is determined as indicating that the start of the decrease of the discharge amount corresponding to the start of the decrease in the number of revolutions of the screw is too late (STEP 309). Further, a time from the start of the decrease in the number of revolutions of the screw to the start of the decrease of the discharge amount (i.e., a lag time T_{dd}) is calculated (STEP 310). An adjustment is performed (STEP 311) to advance the position where the number of revolutions of the screw is started to decrease, such that the lag time T_{dd} matches with the delay time T_{d} calculated in STEP 104. After the adjustment, the above-described procedure is executed again from STEP 301. The above-described procedure is repeated until the measured result falls within the allowable range. When only the adjustment of the response is to be performed, the procedure is brought to an end without shifting to STEP 401.

Thereafter, an adjustment of the discharge amount change rate is performed as shown in Fig. 10. The liquid material is first applied to the work piece or the dummy work piece for adjustment in accordance with the application pattern made up of the corner region and the linear region while the moving speed and the number of revolutions of the screw are changed in the corner region (STEP 401). Then, the applied amount of the liquid material is measured at plural positions in a zone where the moving speed is changed (STEP 402). Then, the results measured in STEP 402 are each compared with a preset allowable range (STEP 404). If the measured value is within the allowable range, the procedure is brought to an end based on determination that there is "no need of adjustment" (STEP 412). If the measured value exceeds the allowable range, it is determined based on the results measured at the plural points in STEP 402 whether there is a zone in which the applied amount decreases (STEP 404). If there is no zone in which the applied amount decreases, the procedure is shifted to STEP 408. If there is such a zone, this is determined as indicating that the decrease rate of the applied amount corresponding to the decrease rate of the number of revolutions of the screw (i.e., the decrease rate of the discharge amount) is too large (STEP 405). Further, the decrease rate of the discharge amount of the liquid material from the screw discharge unit is calculated from both the decrease rate of the applied amount and the deceleration rate of the moving speed in the relevant zone (STEP 406). An adjustment is performed to reduce the decrease rate of the number of revolutions of the screw to be matched with the deceleration rate of the moving speed (STEP 407). After the adjustment, the above-described procedure is executed again from STEP 401.

If it is determined in STEP 404 that there is no zone in which the applied amount decreases, it is determined based on the results measured at the plural points in STEP 402 whether there is a zone in which the applied amount increases (STEP 408). If there is no zone in which the applied amount increases, the procedure is brought to an end. If there is such a zone, this is determined as indicating that the decrease rate of the applied amount corresponding to the decrease rate of the number of revolutions of the screw (i.e., the decrease rate of the discharge amount) is too small (STEP 409). Further, the decrease rate of the discharge amount of the liquid material from the screw discharge unit is calculated from both the decrease rate of the applied amount and the deceleration rate of the moving speed in the relevant zone (STEP 410). An adjustment is performed to increase the decrease rate of the number of revolutions of the screw to be matched with the deceleration rate of the moving speed (STEP 411). After the adjustment, the above-described procedure is executed again from STEP 401. The above-described procedure is repeated is until the measured result falls within the allowable range.

When the procedure is continuously shifted to STEP 401 from STEP 308 or STEP 312, the procedure may be advanced to a further succeeding step while skipping STEP 401. Also, the adjustment procedure shown in Fig. 9 and the adjustment procedure shown in Fig. 10 may be reversed in order. In other words, the adjustment procedure shown in Fig. 10 may be performed prior to the adjustment procedure shown in Fig. 9.

A concrete example of the result of adjusting the discharge amount by applying the liquid material while the moving speed is changed in the linear region and the corner region will be described below. Let consider, for example, the case where the applied amount is measured in terms of cross-sectional area. When the liquid material is applied with a target value of the cross-sectional area set to 6000 [µm²], the cross-sectional area takes the target value of 6000 [µm²] at the number of revolutions of the screw of 3000 [rpm] on condition that the nozzle is moved at the moving speed of 150 [mm/s] in the linear region. Also, the cross-sectional area takes the target value of 6000 [µm²] at the number of revolutions of the screw of 1000 [rpm] on condition that the nozzle is moved along the corner region at the moving speed decelerated to 50 [mm/s].

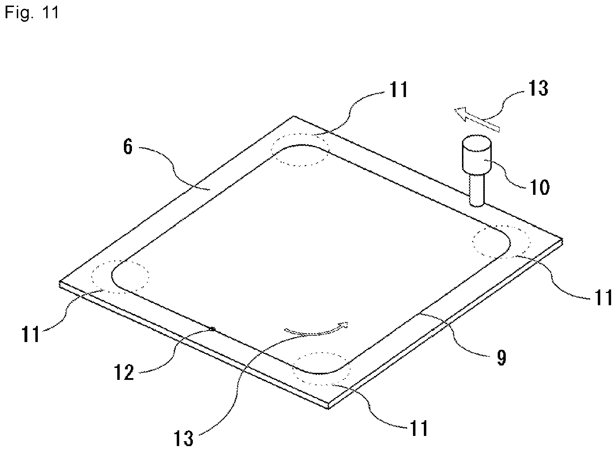

Fig. 11 shows an example in which the liquid material is applied in accordance with the application pattern having a rectangular shape. The application is started from a substantially center of a front side of a work piece and is progressed in the anticlockwise direction. After returning to a start position again, the application is brought to an end. In other words, a start point and an end point of the application are located at the same position to provide a closed application pattern. The application pattern is made up of four linear regions and four corner regions. The corner regions are each arcuate in shape and have the same radius. The liquid material is applied by decelerating the moving speed in each of the four corner regions while the number of revolutions of the screw is decreased in match with the deceleration. Therefore, the adjustment needs to be performed for each of the four corner regions. The adjustments for the four corner regions can be performed separately. As an alternative, it is also possible to execute the measurements in the four corner regions in a lot, to calculate an average value of the measured results, and to perform the adjustments for the four corner regions together based on the average value.

### Industrial Applicability

The present invention relates to a method and an apparatus for discharging a viscous liquid material and a liquid material containing a filler. The present invention can be used, for example, to discharge a creamy solder, a silver paste, a resin-based adhesive, etc. in the field of manufacturing semiconductor devices and FPDs (Flat Panel Displays).

## Claims

1. A liquid material applicator (1) comprising a discharge unit (2) which includes a screw type dispenser for discharging a liquid material, a table (7) on which a work piece (6) is placed, a drive mechanism for relatively moving the discharge unit (2) and the work piece (6), a measurement unit (3) for measuring a discharge amount (Lω) of the liquid material applied to the work piece (6), and a control module for controlling operations of those components,
wherein the control module has a response time calculating function being capable of, prior to the start of application, calculating a response delay time (Td) generated with change of the discharge amount (Lω) of the liquid material when the work piece (6) and the discharge unit (2) are relatively moved at non-constant speeds and the liquid material is continuously applied into a drawing pattern with the liquid material discharged in a non-constant amount, the response time calculating function including
a first step of transmitting a signal for changing the discharge amount (Lω) to the discharge unit (2) during the application in which a relative moving speed is held constant, and storing the time of the signal transmission,
a second step of calculating the time at which the discharge amount (Lω) starts to be changed, by measuring the applied liquid material, and storing the calculated time, and
a third step of storing a differential value between the time stored in the first step and the time stored in the second step as the response delay time (Td) generated when the discharge amount (Lω) of the liquid material is changed.

2. The liquid material applicator (1) according to claim 1, wherein the control module has a response time adjusting function being capable of, prior to the start of application, adjusting a response delay time (Td) generated with change of the discharge amount (Lω) of the liquid material when the work piece (6) and the discharge unit (2) are relatively moved at non-constant speeds and the liquid material is continuously applied into a drawing pattern with the liquid material discharged in a non-constant amount, the response time adjusting function including:
(A) an A1 step of transmitting a signal for changing the discharge amount (Lω) to the discharge unit (2) during the application in which the table (7) and the discharge unit (2) are relatively moved at a constant speed, and storing the time of the signal transmission, an A2 step of calculating the time at which the discharge amount (Lω) starts to be changed, by measuring the applied liquid material, and storing the calculated time, and an A3 step of storing a differential value between the time stored in the A1 step and the time stored in the A2 step as the response delay time (Td) generated when the discharge amount (Lω) is changed,
(B) a B1 step of changing a relative moving speed during the application in which the table (7) and the discharge unit (2) are relatively moved at non-constant speeds, storing the time of changing the relative moving speed, and performing the application by transmitting a signal for changing the discharge amount (Lω) to the discharge unit (2) in accordance with the response delay time (Td), a B2 step of calculating the time at which the discharge amount (Lω) starts to be changed, by measuring the applied liquid material, and storing the calculated time, and a B3 step of storing a differential value between the time stored in the B1 step and the time stored in the B2 step as a response lag time (Tdd) generated when the discharge amount (Lω) is changed, and
(C) a C step of adjusting a gradient of change in the discharge amount (Lω) of the liquid material such that the response delay time (Td) and the response lag time (Tdd) are matched with each other.

3. The liquid material applicator (1) according to claim 1 or 2, wherein the control module has a discharge amount adjusting function being capable of, prior to the start of application, performing an adjustment such that the applied liquid material has a constant volume per unit length, the discharge amount adjusting function including:
a first step of measuring a volume of the liquid material applied to the work piece (6) per unit length and storing the volume as a measured applied amount,
a second step of calculating an increase/decrease rate that is obtained by dividing a preset target value by the measured applied amount, and storing the calculated increase/decrease rate, and
a third step of calculating a next discharge amount condition based on a value obtained by multiplying the current discharge amount (Lω) by the increase/decrease rate stored in the second step, and storing the next discharge amount condition.

4. The liquid material applicator (1) according to claim 3, wherein only when the measured applied amount exceeds an allowable range of the target value, the control module is configured to calculate the increase/decrease rate in the second step and executes the third step.

5. The liquid material applicator (1) according to any one of claims 1 to 4, wherein the control module is configured to control the number of revolutions of the screw (101) and pressure of compressed gas applied to the liquid material.

6. The liquid material applicator (1) according to any one of claims 1 to 5, wherein the measurement unit (3) includes a camera and/or a laser displacement meter.

7. The liquid material applicator (1) according to any one of claims 1 to 6, further comprising a table (8) for adjustment on which a work piece (6) for adjustment is placed.

8. A liquid material application method for continuously applying a liquid material to a work piece (6) by relatively moving the work piece (6) placed on a table (7) and a discharge unit (2) including a screw type dispenser, which is opposed to the work piece (6), at a non-constant speed with the liquid material discharged in a non-constant amount, the method including a response time calculating step of, prior to the start of application, calculating a response delay time (Td) generated when the discharge amount (Lω) of the liquid material is changed,
wherein the response time calculating step includes a first step of transmitting a signal for changing the discharge amount (Lω) to the discharge unit (2) during the application in which a relative moving speed is held constant, and storing the time of the signal transmission,
a second step of calculating the time at which the discharge amount (Lω) starts to be changed, by measuring the applied liquid material, and storing the calculated time, and
a third step of storing a differential value between the time stored in the first step and the time stored in the second step as the response delay time (Td) generated when the discharge amount (Lω) is changed.

9. A liquid material application method according to claim 8, the method including a response time adjusting step of, prior to the start of application, adjusting a response delay time (Td) generated when the discharge amount (Lω) of the liquid material is changed,
wherein the response time adjusting step includes:
(A) an A1 step of transmitting a signal for changing the discharge amount (Lω) to the discharge unit (2) during the application in which the table (7) and the discharge unit (2) are relatively moved at a constant speed, and storing the time of the signal transmission, an A2 step of calculating the time at which the discharge amount (Lω) starts to be changed, by measuring the applied liquid material, and storing the calculated time, and an A3 step of storing a differential value between the time stored in the A1 step and the time stored in the A2 step as the response delay time (Td) generated when the discharge amount (Lω) is changed,
(B) a B1 step of changing a relative moving speed during the application in which the table (7) and the discharge unit (2) are relatively moved at non-constant speeds, storing the time of changing the relative moving speed, and performing the application by transmitting a signal for changing the discharge amount (Lω) to the discharge unit (2) in accordance with the response delay time (Td), a B2 step of calculating the time at which the discharge amount (Lω) starts to be changed, by measuring the applied liquid material, and storing the calculated time, and a B3 step of storing a differential value between the time stored in the B1 step and the time stored in the B2 step as a response lag time (Tdd) generated when the discharge amount (Lω) is changed, and
(C) a C step of adjusting a gradient of change in the discharge amount (Lω) of the liquid material such that the response delay time (Td) and the response lag time (Tdd) are matched with each other.

10. The liquid material application method according to claim 9, wherein when the relative moving speed is changed plural times,
the A2 step and the B2 step are executed by measuring the applied liquid material at plural points near each of positions at which the relative moving speed is changed, calculating average values of changes of the discharge amount (Lω) for the plural positions from measured values, and calculating, based on the average values, the time at which the discharge amount (Lω) starts to be changed, and
the C step is executed by calculating the gradient of change in the discharge amount (Lω) of the liquid material based on the average values of changes of the discharge amount (Lω), which have been calculated in the B2 step.

11. The liquid material application method according to claim 9 or 10, wherein when an application pattern (9) is made up of a linear region and a corner region (11), an application speed is reduced in the corner region (11) than that in the linear region.

12. The liquid material application method according to claim 11, wherein the application pattern (9) has a substantially rectangular shape in which the corner region (11) is in the form of a curved line.

13. The liquid material application method according to claim 8 or 9, the method including a discharge amount adjusting step of, prior to the start of application, performing an adjustment such that the applied liquid material has a constant volume per unit length,
the discharge amount adjusting step comprising:
a first step of measuring a volume of the liquid material applied to the work piece (6) per unit length and storing the volume as a measured applied amount,
a second step of calculating an increase/decrease rate that is obtained by dividing a preset target value by the measured applied amount, and storing the calculated increase/decrease rate, and
a third step of calculating a next discharge amount condition based on a value obtained by multiplying the current discharge amount (Lω) by the increase/decrease rate stored in the second step, and storing the next discharge amount condition.

14. The liquid material application method according to claim 13, wherein only when the measured applied amount exceeds an allowable range of the target value in the second step, the increase/decrease rate is calculated in the second step and the third step is executed.

15. A program comprising instructions which, when the program is executed by an applicator, cause the applicator to carry out the liquid material application method according to any one of claims 8 to 14.

## Patentansprüche

1. Applikator (1) für Flüssigmaterial, der eine Austragseinheit (2), die einen Schneckenspender zum Austragen eines Flüssigmaterials beinhaltet, einen Tisch (7), auf dem ein Werkstück (6) angeordnet ist, einen Antriebsmechanismus zum relativen Bewegen der Austragseinheit (2) und des Werkstücks (6), eine Messeinheit (3) zum Messen einer Austragsmenge (Lω) des auf das Werkstück (6) aufgebrachten Flüssigmaterials und ein Steuermodul zum Steuern der Vorgänge dieser Komponenten aufweist,
wobei das Steuermodul eine Ansprechzeitberechnungsfunktion aufweist, die in der Lage ist, vor Beginn der Applikation eine Ansprechverzögerungszeit (Td) zu berechnen, die bei Änderung der Austragsmenge (Lω) des Flüssigmaterials erzeugt wird, wenn das Werkstück (6) und die Austragseinheit (2) relativ mit nicht-konstanten Geschwindigkeiten bewegt werden und das Flüssigmaterial kontinuierlich in einem Ziehmuster aufgebracht wird, wobei das Flüssigmaterial in einer nicht-konstanten Menge abgegeben wird, wobei die Ansprechzeitberechnungsfunktion Folgendes aufweist
einen ersten Schritt zum Übertragen eines Signals zum Ändern der Austragsmenge (Lω) an die Austragseinheit (2) während der Applikation, in der eine relative Bewegungsgeschwindigkeit konstant gehalten wird, und zum Speichern der Zeit der Signalübertragung,
einen zweiten Schritt zum Berechnen der Zeit, zu der die Austragsmenge (Lω) zu ändern beginnt, durch Messen des aufgebrachten Flüssigmaterials und Speichern der berechneten Zeit, und
einen dritten Schritt zum Speichern eines Differenzwertes zwischen der im ersten Schritt gespeicherten Zeit und der im zweiten Schritt gespeicherten Zeit als Ansprechverzögerungszeit (Td), die erzeugt wird, wenn die Austragsmenge (Lω) des Flüssigmaterials geändert wird.

2. Applikator (1) für Flüssigmaterial nach Anspruch 1, wobei das Steuermodul eine Ansprechzeit-Einstellfunktion aufweist, die in der Lage ist, vor Beginn der Applikation eine Ansprechverzögerungszeit (Td) einzustellen, die bei Änderung der Austragsmenge (Lω) des Flüssigmaterials erzeugt wird, wenn das Werkstück (6) und die Austragseinheit (2) relativ mit nicht konstanten Geschwindigkeiten bewegt werden und das Flüssigmaterial kontinuierlich in einem Ziehmuster mit dem in einer nicht-konstanten Menge ausgetragenen Flüssigmaterial aufgebracht wird, wobei die Ansprechzeit-Einstellfunktion Folgendes aufweist:
(A) einen A1-Schritt zum Übertragen eines Signals zum Ändern der Austragsmenge (Lω) an die Austragseinheit (2) während der Applikation, in der der Tisch (7) und die Austragseinheit (2) relativ mit einer konstanten Geschwindigkeit bewegt werden, und zum Speichern der Zeit der Signalübertragung, einen A2-Schritt zum Berechnen der Zeit, in der die Austragsmenge (Lω) zu ändern beginnt, durch Messen des aufgebrachten Flüssigmaterials und Speichern der berechneten Zeit und eines A3-Schrittes zum Speichern eines Differenzwertes zwischen der in dem A1-Schritt gespeicherten Zeit und der in dem A2-Schritt gespeicherten Zeit als Ansprechverzögerungszeit (Td), die erzeugt wird, wenn die Austragsmenge (Lω) geändert wird,
(B) einen B1-Schritt zum Ändern einer relativen Bewegungsgeschwindigkeit während der Applikation, bei der der Tisch (7) und die Austragseinheit (2) relativ mit nicht-konstanten Geschwindigkeiten bewegt werden, Speichern der Zeit zum Ändern der relativen Bewegungsgeschwindigkeit und Ausführen der Applikation durch Übertragen eines Signals zum Ändern der Austragsmenge (Lω) an die Austragseinheit (2) gemäß der Ansprechverzögerungszeit (Td), einen B2-Schritt zum Berechnen der Zeit, zu der die Austragsmenge (Lω) zu ändern beginnt, durch Messen des aufgetragenen Flüssigmaterials und Speichern der berechneten Zeit, und einen B3-Schritt zum Speichern eines Differenzwertes zwischen der in dem B1-Schritt gespeicherten Zeit und der in dem B2-Schritt gespeicherten Zeit als Antwortnachlaufzeit (Tdd), die erzeugt wird, wenn die Austragsmenge (Lω) geändert wird, und
(C) einen C-Schritt zum Einstellen eines Änderungsgradienten der Austragsmenge (Lω) des Flüssigmaterials, so dass die Ansprechverzögerungszeit (Td) und die Antwortnachlaufzeit (Tdd) miteinander abgestimmt sind.

3. Applikator (1) für Flüssigmaterial nach Anspruch 1 oder 2, wobei das Steuermodul eine Austragsmengeneinstellfunktion aufweist, die vor Beginn der Applikation eine Einstellung derart durchführen kann, dass das aufgetragene Flüssigmaterial ein konstantes Volumen pro Längeneinheit aufweist, wobei die Austragsmengeneinstellfunktion Folgendes beinhaltet:
einen ersten Schritt zum Messen eines Volumens des auf das Werkstück (6) aufgebrachten Flüssigmaterials pro Längeneinheit und zum Speichern des Volumens als gemessene aufgebrachte Menge,
einen zweiten Schritt zum Berechnen einer Erhöhungs- und Verminderungsrate, die durch Division eines voreingestellten Sollwerts durch die gemessene aufgebrachte Menge erhalten wird, und Speichern der berechneten Erhöhungs- und Verminderungsrate, und
einen dritten Schritt zum Berechnen einer nächsten Austragsmengenbedingung basierend auf einem Wert, der durch Multiplizieren der derzeitigen Austragsmenge (Lω) mit der in dem zweiten Schritt gespeicherten Erhöhungs- und Verminderungsrate erhalten wird, und Speichern der nächsten Austragsmengenbedingung.

4. Applikator (1) für Flüssigmaterial nach Anspruch 3, wobei nur dann, wenn die gemessene aufgetragene Menge einen zulässigen Bereich des Sollwerts überschreitet, das Steuermodul konfiguriert ist, um die Erhöhungs- und Verminderungsrate im zweiten Schritt zu berechnen und den dritten Schritt auszuführen.

5. Applikator (1) für Flüssigmaterial nach einem der Ansprüche 1 bis 4, wobei das Steuermodul konfiguriert ist, um die Anzahl der Umdrehungen der Schraube (101) und den Druck des auf das Flüssigmaterial aufgebrachten Drucks zu steuern.

6. Applikator (1) für Flüssigmaterial nach einem der Ansprüche 1 bis 5, wobei die Messeinheit (3) eine Kamera und/oder ein Laser-Verschiebungsmessgerät aufweist.

7. Applikator (1) für Flüssigmaterial nach einem der Ansprüche 1 bis 6, ferner umfassend einen Tisch (8) zum Einstellen, auf dem ein Werkstück (6) zum Einstellen platziert ist.

8. Flüssigmaterial-Auftragsverfahren zum kontinuierlichen Auftragen eines Flüssigmaterials auf ein Werkstück (6) durch relatives Bewegen des auf einem Tisch (7) platzierten Werkstücks (6) und einer Austragseinheit (2) mit einem schneckenförmigen Spender, der dem Werkstück (6) gegenüberliegt, mit einer nicht-konstanten Geschwindigkeit, wobei das Flüssigmaterial in einer nicht-konstanten Menge ausgetragen wird, wobei das Verfahren einen Antwortzeitberechnungsschritt beinhaltet, bei dem vor dem Beginn der Applikation eine Ansprechverzögerungszeit (Td) berechnet wird, die erzeugt wird, wenn die Austragsmenge (Lω) des Flüssigmaterials verändert wird,
wobei der Antwortzeitberechnungsschritt einen ersten Schritt zum Übertragen eines Signals zum Ändern der Austragsmenge (Lω) an die Austragseinheit (2) während der Applikation, in der eine relative Bewegungsgeschwindigkeit konstant gehalten wird, und zum Speichern der Zeit der Signalübertragung,
einen zweiten Schritt zum Berechnen der Zeit, zu der die Austragsmenge (Lω) zu ändern beginnt, durch Messen des aufgebrachten Flüssigmaterials und Speichern der berechneten Zeit, und
einen dritten Schritt zum Speichern eines Differenzwertes zwischen der im ersten Schritt gespeicherten Zeit und der im zweiten Schritt gespeicherten Zeit als Ansprechverzögerungszeit (Td) aufweist, die erzeugt wird, wenn die Austragsmenge (Lω) geändert wird.

9. Flüssigmaterial-Auftragsverfahren nach Anspruch 8, wobei das Verfahren einen Ansprechzeiteinstellschritt beinhaltet, bei dem vor dem Beginn der Applikation eine Ansprechverzögerungszeit (Td) eingestellt wird, die erzeugt wird, wenn die Austragsmenge (Lω) des Flüssigmaterials geändert wird,
wobei der Schritt zum Einstellen der Ansprechzeit Folgendes beinhaltet:
(A) einen A1-Schritt zum Übertragen eines Signals zum Ändern der Austragsmenge (Lω) an die Austragseinheit (2) während der Anwendung, in der der Tisch (7) und die Austragseinheit (2) relativ mit einer konstanten Geschwindigkeit bewegt werden, und zum Speichern der Zeit der Signalübertragung, einen A2-Schritt zum Berechnen der Zeit, in der die Austragsmenge (Lω) beginnt, geändert zu werden, durch Messen des aufgebrachten Flüssigmaterials und Speichern der berechneten Zeit und eines A3-Schrittes zum Speichern eines Differenzwertes zwischen der in dem A1-Schritt gespeicherten Zeit und der in dem A2-Schritt gespeicherten Zeit als Ansprechverzögerungszeit (Td), die erzeugt wird, wenn die Austragsmenge (Lω) geändert wird,
(B) einen B1-Schritt zum Ändern einer relativen Bewegungsgeschwindigkeit während der Applikation, bei der der Tisch (7) und die Austragseinheit (2) relativ mit nicht-konstanten Geschwindigkeiten bewegt werden, Speichern der Zeit zum Ändern der relativen Bewegungsgeschwindigkeit und Ausführen der Applikation durch Übertragen eines Signals zum Ändern der Austragsmenge (Lω) an die Austragseinheit (2) gemäß der Ansprechverzögerungszeit (Td), einen B2-Schritt zum Berechnen der Zeit, zu der die Austragsmenge (Lω) zu ändern beginnt, durch Messen des aufgetragenen Flüssigmaterials und Speichern der berechneten Zeit, und einen B3-Schritt zum Speichern eines Differenzwertes zwischen der in dem B1-Schritt gespeicherten Zeit und der in dem B2-Schritt gespeicherten Zeit als Antwortnachlaufzeit (Tdd), die erzeugt wird, wenn die Austragsmenge (Lω) geändert wird, und
(C) einen C-Schritt zum Einstellen eines Änderungsgradienten der Austragsmenge (Lω) des Flüssigmaterials, so dass die Ansprechverzögerungszeit (Td) und die Antwortnachlaufzeit (Tdd) miteinander abgestimmt sind.

10. Flüssigmaterial-Auftragsverfahren nach Anspruch 9, wobei, wenn die relative Bewegungsgeschwindigkeit mehrfach geändert wird,
der A2-Schritt und der B2-Schritt ausgeführt werden, indem das aufgetragene Flüssigmaterial an mehreren Punkten in der Nähe jeder der Positionen gemessen wird, an denen die relative Bewegungsgeschwindigkeit geändert wird, Durchschnittswerte von Änderungen der Austragsmenge (Lω) für die mehreren Positionen aus Messwerten berechnet werden und basierend auf den Durchschnittswerten der Zeitpunkt berechnet wird, zu dem die Austragsmenge (Lω) beginnt, geändert zu werden, und
der C-Schritt durch Berechnen des Änderungsgradienten der Austragsmenge (Lω) des Flüssigmaterials basierend auf den Durchschnittswerten der Änderungen der Austragsmenge (Lω) ausgeführt wird, die im B2-Schritt berechnet wurden.

11. Flüssigmaterial-Auftragsverfahren nach Anspruch 9 oder 10, wobei, wenn ein Auftragsmuster (9) aus einem linearen Bereich und einem Eckbereich (11) besteht, eine Auftragsgeschwindigkeit im Eckbereich (11) verglichen zu dem linearen Bereich reduziert ist.

12. Flüssigmaterial-Auftragsverfahren nach Anspruch 11, wobei das Auftragsmuster (9) eine im Wesentlichen rechteckige Form aufweist, in der der Eckbereich (11) in Form einer gekrümmten Linie vorliegt.

13. Flüssigmaterial-Auftragsverfahren nach Anspruch 8 oder 9, wobei das Verfahren einen Schritt zum Einstellen der Austragsmenge beinhaltet, bei dem vor Beginn der Applikation eine Einstellung durchgeführt wird, so dass das aufgetragene Flüssigmaterial ein konstantes Volumen pro Längeneinheit aufweist,
wobei der Schritt zum Einstellen der Austragsmenge Folgendes aufweist:
einen ersten Schritt zum Messen eines Volumens des auf das Werkstück (6) aufgebrachten Flüssigmaterials pro Längeneinheit und zum Speichern des Volumens als gemessene aufgebrachte Menge,
einen zweiten Schritt zum Berechnen einer Erhöhungs- und Verminderungsrate, die durch Division eines voreingestellten Sollwerts durch die gemessene angewandte Menge erhalten wird, und Speichern der berechneten Erhöhungs- und Verminderungsrate, und
einen dritten Schritt zum Berechnen einer nächsten Austragsmengenbedingung basierend auf einem Wert, der durch Multiplizieren der aktuellen Austragsmenge (Lω) mit der in dem zweiten Schritt gespeicherten Erhöhungs- und Verminderungsrate erhalten wird, und Speichern der nächsten Austragsmengenbedingung.

14. Flüssigmaterial-Auftragsverfahren nach Anspruch 13, wobei nur dann, wenn die gemessene aufgetragene Menge einen zulässigen Bereich des Sollwerts im zweiten Schritt überschreitet, die Erhöhungs- und Verringerungsrate im zweiten Schritt berechnet wird und der dritte Schritt ausgeführt wird.

15. Programm mit Anweisungen, die, wenn das Programm von einem Applikator ausgeführt wird, bewirken, dass der Applikator das Flüssigmaterial-Auftragsverfahren nach einem der Ansprüche 8 bis 14 durchführt.

## Revendications

1. Applicateur de matière liquide (1) comprenant une unité d'évacuation (2) qui inclut un distributeur de type à vis pour évacuer une matière liquide, une table (7) sur laquelle une pièce à travailler (6) est placée, un mécanisme d'entraînement pour déplacer de manière relative l'unité d'évacuation (2) et la pièce (6), une unité de mesure (3) pour mesurer une quantité d'évacuation (Lω) de la matière liquide appliquée sur la pièce à travailler (6), et un module de commande pour commander les opérations de ces composants,
dans lequel le module de commande possède une fonction de calcul de temps de réponse étant apte à, avant le début de l'application, calculer un temps de délai de réponse (Td) généré avec la modification de la quantité d'évacuation (Lω) de la matière liquide lorsque la pièce à travailler (6) et l'unité d'évacuation (2) sont déplacées de manière relative à des vitesses non constantes et la matière liquide est appliquée en continu en un motif de dessin avec la matière liquide évacuée en une quantité non constante, la fonction de calcul de temps de réponse incluant
une première étape de transmission d'un signal pour modifier la quantité d'évacuation (Lω) à l'unité d'évacuation (2) au cours de l'application dans laquelle une vitesse de déplacement relative est maintenue constante, et de stockage du temps de la transmission de signal,
une deuxième étape de calcul du temps auquel la quantité d'évacuation (Lω) commence à être modifiée, par la mesure de la matière liquide appliquée, et de stockage du temps calculé, et
une troisième étape de stockage d'une valeur différentielle entre le temps stocké à la première étape et le temps stocké à la deuxième étape en tant que temps de délai de réponse (Td) généré lorsque la quantité d'évacuation (Lω) de la matière liquide est modifiée.

2. Applicateur de matière liquide (1) selon la revendication 1, dans lequel le module de commande possède une fonction de réglage de temps de réponse étant apte à, avant le début de l'application, régler un temps de délai de réponse (Td) généré avec la modification de la quantité d'évacuation (Lω) de la matière liquide lorsque la pièce à travailler (6) et l'unité d'évacuation (2) sont déplacées de manière relative à des vitesses non constantes et la matière liquide est appliquée en continu en un motif de dessin avec la matière liquide évacuée en une quantité non constante, la fonction de réglage de temps de réponse incluant :
(A) une étape A1 de transmission d'un signal pour modifier la quantité d'évacuation (Lω) à l'unité d'évacuation (2) au cours de l'application dans laquelle la table (7) et l'unité d'évacuation (2) sont déplacées de manière relative à une vitesse constante, et de stockage du temps de la transmission de signal, une étape A2 de calcul du temps auquel la quantité d'évacuation (Lω) commence à être modifiée, par la mesure de la matière liquide appliquée, et de stockage du temps calculé, et une étape A3 de stockage d'une valeur différentielle entre le temps stocké à l'étape A1 et le temps stocké à l'étape A2 en tant que temps de délai de réponse (Td) généré lorsque la quantité d'évacuation (Lω) est modifiée,
(B) une étape B1 de modification d'une vitesse de déplacement relative au cours de l'application dans laquelle la table (7) et l'unité d'évacuation (2) sont déplacées de manière relative à des vitesses non constantes, de stockage du temps de modification de la vitesse de déplacement relative, et de réalisation de l'application par la transmission d'un signal pour modifier la quantité d'évacuation (Lω) à l'unité d'évacuation (2) en fonction du temps de délai de réponse (Td), une étape B2 de calcul du temps auquel la quantité d'évacuation (Lω) commence à être modifiée, par la mesure de la matière liquide appliquée, et de stockage du temps calculé, et une étape B3 de stockage d'une valeur différentielle entre le temps stocké à l'étape B1 et le temps stocké à l'étape B2 en tant que temps de latence de réponse (Tdd) généré lorsque la quantité d'évacuation (Lω) est modifiée, et
(C) une étape C de réglage d'un gradient de modification dans la quantité d'évacuation (Lω) de la matière liquide de telle sorte que le temps de délai de réponse (Td) et le temps de latence de réponse (Tdd) correspondent l'un à l'autre.

3. Applicateur de matière liquide (1) selon la revendication 1 ou 2, dans lequel le module de commande possède une fonction de réglage de quantité d'évacuation étant apte à, avant le début de l'application, réaliser un réglage de sorte que la matière liquide appliquée possède un volume constant par unité de longueur, la fonction de réglage de quantité d'évacuation incluant :
une première étape de mesure d'un volume de la matière liquide appliquée sur la pièce à travailler (6) par unité de longueur et de stockage du volume en tant que quantité appliquée mesurée,
une deuxième étape de calcul d'un taux d'augmentation/de diminution qui est obtenu par la division d'une valeur cible prédéfinie par la quantité appliquée mesurée et de stockage du taux d'augmentation/de diminution calculé, et
une troisième étape de calcul d'une condition de quantité d'évacuation suivante sur la base d'une valeur obtenue par la multiplication de la quantité d'évacuation actuelle (Lω) par le taux d'augmentation/de diminution stocké à la deuxième étape, et de stockage de la condition de quantité d'évacuation suivante.

4. Applicateur de matière liquide (1) selon la revendication 3, dans lequel uniquement lorsque la quantité appliquée mesurée dépasse une plage admissible de la valeur cible, le module de commande est configuré pour calculer le taux d'augmentation/de diminution à la deuxième étape et exécute la troisième étape.

5. Applicateur de matière liquide (1) selon l'une quelconque des revendications 1 à 4, dans lequel le module de commande est configuré pour commander le nombre de révolutions de la vis (101) et la pression d'un gaz comprimé appliqué à la matière liquide.

6. Applicateur de matière liquide (1) selon l'une quelconque des revendications 1 à 5, dans lequel l'unité de mesure (3) inclut une caméra et/ou un appareil de mesure de déplacement par laser.

7. Applicateur de matière liquide (1) selon l'une quelconque des revendications 1 à 6, comprenant en outre une table (8) à régler sur laquelle une pièce à travailler (6) à régler est placée.

8. Procédé d'application de matière liquide pour appliquer en continu une matière liquide sur une pièce à travailler (6) par le déplacement de manière relative de la pièce à travailler (6) placée sur une table (7) et d'une unité d'évacuation (2) incluant un distributeur de type à vis, qui est opposée à la pièce à travailler (6), à une vitesse non constante avec la matière liquide évacuée en une quantité non constante, le procédé incluant une étape de calcul de temps de réponse consistant à, avant le début de l'application, calculer un temps de délai de réponse (Td) généré lorsque la quantité d'évacuation (Lω) de la matière liquide est modifiée,
dans lequel l'étape de calcul de temps de réponse inclut une première étape de transmission d'un signal pour modifier la quantité d'évacuation (Lω) à l'unité d'évacuation (2) au cours de l'application dans laquelle une vitesse de déplacement relative est maintenue constante, et de stockage du temps de la transmission de signal,
une deuxième étape de calcul du temps auquel la quantité d'évacuation (Lω) commence à être modifiée, par la mesure de la matière liquide appliquée, et de stockage du temps calculé, et
une troisième étape de stockage d'une valeur différentielle entre le temps stocké à la première étape et le temps stocké à la deuxième étape en tant que temps de délai de réponse (Td) généré lorsque la quantité d'évacuation (Lω) est modifiée.

9. Procédé d'application de matière liquide selon la revendication 8, le procédé incluant une étape de réglage de temps de réponse consistant à, avant le début de l'application, régler un temps de délai de réponse (Td) généré lorsque la quantité d'évacuation (Lω) du matériau liquide est modifiée,
dans lequel l'étape de réglage de temps de réponse inclut :
(A) une étape A1 de transmission d'un signal pour modifier la quantité d'évacuation (Lω) à l'unité d'évacuation (2) au cours de l'application dans laquelle la table (7) et l'unité d'évacuation (2) sont déplacées de manière relative à une vitesse constante, et de stockage du temps de la transmission de signal, une étape A2 de calcul du temps auquel la quantité d'évacuation (Lω) commence à être modifiée, par la mesure de la matière liquide appliquée, et de stockage du temps calculé, et une étape A3 de stockage d'une valeur différentielle entre le temps stocké à l'étape A1 et le temps stocké à l'étape A2 en tant que temps de délai de réponse (Td) généré lorsque la quantité d'évacuation (Lω) est modifiée,
(B) une étape B1 de modification d'une vitesse de déplacement relative au cours de l'application dans laquelle la table (7) et l'unité d'évacuation (2) sont déplacées de manière relative à des vitesses non constantes, de stockage du temps de modification de la vitesse de déplacement relative et de réalisation de l'application par la transmission d'un signal pour modifier la quantité d'évacuation (Lω) à l'unité d'évacuation (2) en fonction du temps de délai de réponse (Td), une étape B2 de calcul du temps auquel la quantité d'évacuation (Lω) commence à être modifiée, par la mesure de la matière liquide appliquée, et de stockage du temps calculé, et une étape B3 de stockage d'une valeur différentielle entre le temps stocké à l'étape B1 et le temps stocké à l'étape B2 en tant que temps de latence de réponse (Tdd) généré lorsque la quantité d'évacuation (Lω) est modifiée, et
(C) une étape C de réglage d'un gradient de modification dans la quantité d'évacuation (Lω) de la matière liquide de telle sorte que le temps de délai de réponse (Td) et le temps de latence de réponse (Tdd) correspondent l'un à l'autre.

10. Procédé d'application de matière liquide selon la revendication 9, dans lequel lorsque la vitesse de déplacement relative est modifiée plusieurs fois,
l'étape A2 et l'étape B2 sont exécutées par la mesure de la matière liquide appliquée en plusieurs points proches de chacune de positions auxquelles la vitesse de déplacement relative est modifiée, le calcul de valeurs moyennes de modifications de la quantité d'évacuation (Lω) pour les plusieurs positions à partir de valeurs mesurées, et le calcul, sur la base des valeurs moyennes, du temps auquel la quantité d'évacuation (Lω) commence à être modifiée, et
l'étape C est exécutée par le calcul du gradient de modification dans la quantité d'évacuation (Lω) de la matière liquide sur la base des valeurs moyennes de modifications de la quantité d'évacuation (Lω), qui ont été calculées à l'étape B2.

11. Procédé d'application de matière liquide selon la revendication 9 ou 10, dans lequel lorsqu'un motif d'application (9) est constitué d'une région linéaire et d'une région de coin (11), une vitesse d'application est réduite dans la région de coin (11) par rapport à celle dans la région linéaire.

12. Procédé d'application de matière liquide selon la revendication 11, dans lequel le motif d'application (9) possède une forme sensiblement rectangulaire dans laquelle la région de coin (11) est sous la forme d'une ligne courbe.

13. Procédé d'application de matière liquide selon la revendication 8 ou 9, le procédé incluant une étape de réglage de quantité d'évacuation consistant à, avant le début de l'application, réaliser un réglage de sorte que la matière liquide appliquée possède un volume constant par unité de longueur,
l'étape de réglage de quantité d'évacuation comprenant :
une première étape de mesure d'un volume de la matière liquide appliquée sur la pièce à travailler (6) par unité de longueur et de stockage du volume en tant que quantité appliquée mesurée,
une deuxième étape de calcul d'un taux d'augmentation/de diminution qui est obtenu par la division d'une valeur cible prédéfinie par la quantité appliquée mesurée et de stockage du taux d'augmentation/de diminution calculé, et
une troisième étape de calcul d'une condition de quantité d'évacuation suivante sur la base d'une valeur obtenue par la multiplication de la quantité d'évacuation actuelle (Lω) par le taux d'augmentation/de diminution stocké à la deuxième étape, et de stockage de la condition de quantité d'évacuation suivante.

14. Procédé d'application de matière liquide selon la revendication 13, dans lequel uniquement lorsque la quantité appliquée mesurée dépasse une plage admissible de la valeur cible à la deuxième étape, le taux d'augmentation/de diminution est calculé à la deuxième étape et la troisième étape est exécutée.

15. Programme comprenant des instructions qui, lorsque le programme est exécuté par un applicateur, amènent l'applicateur à mettre en œuvre le procédé d'application de matière liquide selon l'une quelconque des revendications 8 à 14.
